# EUROPÄISCHE PATENTSCHRIFT

(11) **EP 4 016 102 B1**
(45) Veröffentlichungstag und Bekanntmachung des Hinweises auf die Patenterteilung: **05.07.2023**
(21) Anmeldenummer: 21214818.3
(22) Anmeldetag: 15.12.2021
(51) Int. Cl.: G01R 31/62

(54) **AUTOMATISCHES ÜBERWACHEN EINER TRANSFORMATORVORRICHTUNG**
AUTOMATIC MONITORING OF A TRANSFORMER DEVICE
SURVEILLANCE AUTOMATIQUE D'UN DISPOSITIF TRANSFORMATEUR

(30) Priorität: 17.12.2020 AT 511122020
(43) Veröffentlichungstag der Anmeldung: 22.06.2022
(73) Patentinhaber: Omicron Energy Solutions GmbH, 12099 Berlin (DE)
(72) Erfinder: COBET, Andreas, 12203 Berlin (DE)
(74) Vertreter: Banzer, Hans-Jörg

(56) Entgegenhaltungen:
- CN-A- 111 553 918
- CN-A- 111 693 902
- CN-B- 107 831 415
- US-A1- 2009 216 479
- US-A1- 2018 348 283

## Beschreibung

### GEBIET DER ERFINDUNG

Die vorliegende Erfindung betrifft ein Verfahren zum automatischen Überwachen einer Transformatorvorrichtung, insbesondere zur Überwachung eines Verlustfaktors einer Transformatorvorrichtung im Freien, sowie ein Überwachungssystem für eine Transformatorvorrichtung, welches zur Durchführung des Verfahrens ausgestaltet ist.

### HINTERGRUND DER ERFINDUNG

Transformatoren, insbesondere Leistungstransformatoren in Energieübertragungsnetzen oder Netzkoppler, sind häufig starken physikalischen Belastungen ausgesetzt, wie z.B. hohen Lastströmen oder inneren oder äußeren Kurzschlüssen. Dadurch können Beschädigungen insbesondere an Isolationen beispielsweise zwischen einzelnen Wicklungen oder innerhalb einer Wicklung durch z.B. eine Überlastung oder eine Isolationsalterung auftreten. Diese Schäden können schwerwiegende Folgen für die Betriebssicherheit des Transformators haben. Um den Zustand eines Transformators zu überwachen, werden daher regelmäßige Untersuchungen und Wartungen durchgeführt, wie z.B. eine Untersuchung des Transformatoröls oder elektrische Untersuchungen, wie z.B. eine Messung der Wicklungswiderstände oder eine Bestimmung der Kapazität oder des Verlustfaktors. Insbesondere Kapazität und Verlustfaktor ändern sich durch Alterung nur sehr langsam. Bei kontinuierlichen Langzeitüberwachungen von Kapazität und/oder Verlustfaktor können langsame geringfügige Änderungen als Trend erkannt werden.

Leistungstransformatoren können beispielsweise in einem mit Transformatoröl gefüllten Transformatorkessel angeordnet sein. In Energieübertragungsnetzen sind Transformatorkessel mit Leistungstransformatoren häufig im Freien angeordnet. Der Transformatorkessel weist Durchführungen auf, welche den Transformator mit Hochspannungsleitungen koppeln. Bei einer Überwachung des Zustands des Transformators können unterschiedliche Umwelteinflüsse, beispielsweise Feuchtigkeit und Staub an den Durchführungen, die Messungen beeinflussen. Um diese umweltbedingten Beeinflussungen zu kompensieren, können die Messwerte beispielsweise über der Zeit gemittelt werden. Durch die Mittelung über der Zeit können jedoch potentielle Fehler, beispielsweise Fehler an der Durchführung, erst zu einem späteren Zeitpunkt ersichtlich werden. Außerdem findet eine Verfälschung der richtig gemessenen Werte durch die gestörten Werte statt, sodass auf der Grundlage des Mittelwertes insbesondere bei Langzeitüberwachungen der Zustand des Transformators nicht zuverlässig bestimmt werden kann.

Ein Verfahren zum automatischen Überwachen einer Transformatorvorrichtung nach dem Oberbegriff des Anspruches 1 und ein entsprechend ausgestaltetes Überwachungssystem nach dem Oberbegriff des Anspruches 13 sind aus der Druckschrift CN 107 831 415 B bekannt.

Ähnliche Lösungen sind auch in den Druckschriften CN 111 553 918 A, CN 111 693 902 A, US 2009/0216479 A1 und US 2018/0348283 A1 offenbart.

### ZUSAMMENFASSUNG DER ERFINDUNG

Aufgabe der vorliegenden Erfindung ist es, die Überwachung von Transformatoren, insbesondere Transformatoren im Freien, zu verbessern. Insbesondere ist es eine Aufgabe der vorliegenden Erfindung, eine zuverlässige Langzeitüberwachung von Transformatoren zu ermöglichen.

Gemäß der vorliegenden Erfindung wird diese Aufgabe durch ein Verfahren zum automatischen Überwachen einer Transformatorvorrichtung gemäß Anspruch 1 und ein Überwachungssystem für eine Transformatorvorrichtung gemäß Anspruch 13 gelöst. Die abhängigen Ansprüche definieren Ausführungsformen der Erfindung.

Ein Verfahren zum automatischen Überwachen einer Transformatorvorrichtung umfasst ein Erfassen einer Transformatormesswertinformation, welche eine zu überwachende elektrische Eigenschaft der Transformatorvorrichtung anzeigt, mit einer Messvorrichtung. Die Transformatormesswertinformationen umfasste beispielsweise einen Verlustfaktor der Transformatorvorrichtung, beispielsweise einen jeweiligen Verlustfaktor für jede Phase bei einer mehrphasigen Transformatorvorrichtung. Die Transformatormesswertinformation kann weitere Messwerte umfassen, beispielsweise eine Kapazität. Die Transformatorvorrichtung kann beispielsweise im Freien auf einer Landfläche angeordnet sein. Die Transformatorvorrichtung kann beispielsweise einen Hochspannungstransformator in beispielsweise einem Umspannwerk umfassen. Die Transformatorvorrichtung kann beispielsweise einen Transformator in einem Transformatorkessel mit Leitungsdurchführungen für Leitungen zu dem Transformator umfassen. Die Transformatormesswertinformation kann beispielsweise an den Leitungsdurchführungen des Transformatorkessels der Transformatorvorrichtung erfasst werden. Zusätzlich wird bei dem Verfahren eine Feuchtigkeitsmesswertinformation mit einem Feuchtigkeitssensor erfasst. Die Feuchtigkeitsmesswertinformation zeigt eine Feuchtigkeit am Ort der Transformatorvorrichtung an. Beispielsweise kann der Feuchtigkeitssensor in einer Umgebung der Transformatorvorrichtung im Freien angeordnet sein. Zum Beispiel kann der Feuchtigkeitssensor in einem Umkreis der Transformatorvorrichtung von weniger als 100 m, vorzugsweise weniger als 20 m oder weniger als 5 m angeordnet sein. Bei dem Verfahren wird mittels einer Auswerteschaltung ein Überwachungsergebnis für die Transformatorvorrichtung in Abhängigkeit von der Transformatormesswertinformation und der Feuchtigkeitsmesswertinformation erzeugt.

Feuchtigkeit an den Leitungsdurchführungen kann eine Verlustfaktormessung erheblich verfälschen. Durch die Messung der Feuchtigkeit am Ort der Transformatorvorrichtung kann die aktuelle Feuchtigkeit bei der Erzeugung des Überwachungsergebnisses berücksichtigt werden und somit eine Verfälschung des Überwachungsergebnisses aufgrund von Feuchtigkeit vermieden werden. Das Überwachungsergebnis kann beispielsweise ein Graph sein, welcher einen Verlustfaktor oder eine Kapazität über der Zeit anzeigt.

Erfindungsgemäß wird in Abhängigkeit von der Feuchtigkeitsmesswertinformation zumindest ein Teil der Transformatormesswertinformation beim Erzeugen des Überwachungsergebnisses nicht berücksichtigt. Beispielsweise können Transformatormesswerte der Transformatormesswertinformation, welche erfasst wurden, während die Feuchtigkeitsmesswertinformation angezeigt hat, dass an dem Ort der Transformatorvorrichtung eine erhöhte Feuchtigkeit vorlag, bei der Erzeugung des Überwachungsergebnisses unberücksichtigt bleiben. Dadurch kann vermieden werden, dass verfälschende Messwerte in das Überwachungsergebnis einfließen. Insbesondere Langzeitüberwachungen können somit zuverlässig durchgeführt werden.

Beispielsweise kann die Transformatormesswertinformation mehrere zeitlich nacheinander erfasste Transformatormesswerte umfassen. Transformatormesswerte können beispielsweise in regelmäßigen zeitlichen Abständen von beispielsweise einigen Sekunden bis hin zu einigen Stunden erfasst werden. Ebenso kann die Feuchtigkeitsmesswertinformation mehrere zeitlich nacheinander erfasste Feuchtigkeitsmesswerte umfassen. Ein jeweiliger Transformatormesswert der mehreren Transformatormesswerte kann in Abhängigkeit von der Feuchtigkeitsmesswertinformation als plausibel oder nicht-plausibel bewertet werden. Beispielsweise kann jeder Transformatormesswert mit einem zugehörigen Zeitstempel versehen werden und jeder Feuchtigkeitsmesswert kann ebenfalls mit einem zugehörigen Zeitstempel versehen werden. Wenn ein Transformatormesswert zu einem Zeitpunkt erfasst wurde, welcher im Wesentlichen oder zumindest näherungsweise einem Erfassungszeitpunkt eines Feuchtigkeitsmesswertes entspricht, kann dieser Feuchtigkeitsmesswert dem Transformatormesswert zugeordnet werden. Wenn ein Feuchtigkeitsmesswert eine Feuchtigkeit am Ort der Transformatorvorrichtung anzeigt, welche darauf hindeutet, dass der zugeordnete Transformatormesswert durch die Feuchtigkeit verfälscht wurde, kann dieser Transformatormesswert als nicht-plausibel bewertet werden. Anderenfalls wird dieser Transformatormesswert als plausibel bewertet. Das Überwachungsergebnis wird unabhängig von dem Transformatormesswert erzeugt, wenn der Transformatormesswert als nicht-plausibel bewertet wurde. Anders ausgedrückt wird das Überwachungsergebnis nur in Abhängigkeit von den Transformatormesswerten erzeugt, welche als plausibel bewertet wurden.

Anders ausgedrückt kann bei dem Verfahren einem Transformatormesswert der mehreren Transformatormesswerte jeweils mindestens ein zeitlich korrelierter Feuchtigkeitsmesswert der mehreren Feuchtigkeitsmesswerte zugeordnet werden. Der Transformatormesswert wird in Abhängigkeit von dem zugeordneten mindestens einen Feuchtigkeitsmesswert als plausibel oder nicht-plausibel bewertet. Beispielsweise kann ein Feuchtigkeitsmesswert, welcher zeitlich am nächsten zu einem Transformatormesswert erfasst wurde, diesem Transformatormesswert zugeordnet werden und in Abhängigkeit von dem Feuchtigkeitsmesswert der Transformatormesswert als plausibel oder nicht-plausibel bewertet werden. Bei einem anderen Beispiel wird mindestens ein Feuchtigkeitsmesswert der mehreren Feuchtigkeitsmesswerte, welcher in einem vorgegebenen Zeitbereich in Bezug auf einen Erfassungszeitpunkt eines Transformatormesswerts erfasst wurde, dem entsprechenden Transformatormesswert zugeordnet. In einer Ausführungsform kann der vorgegebene Zeitbereich von einem ersten Zeitpunkt vor dem Erfassungszeitpunkt des Transformatormesswerts bis zu einem zweiten Zeitpunkt nach dem Erfassungszeitpunkt des Transformatormesswerts reichen. Dadurch können einem Transformatormesswert mehrere zeitlich korrelierte Feuchtigkeitsmesswerte zugeordnet werden. Der Transformatormesswert kann beispielsweise als nicht-plausibel bewertet werden, sobald einer der ihm zugeordneten Feuchtigkeitsmesswerte anzeigt, dass in der Umgebung der Transformatorvorrichtung eine Feuchtigkeit vorlag, von welcher der Transformatormesswert voraussichtlich beeinflusst wurde und somit ungenau ist.

Der vorgegebene Zeitbereich kann beispielsweise einen Bereich von einigen Minuten bis einigen Stunden vor dem Erfassungszeitpunkt des Transformatormesswerts beginnen und einige Minuten bis einige Stunden nach dem Erfassungszeitpunkt des Transformatormesswerts enden. Beispielsweise kann der Zeitbereich derart vorgegeben sein, dass er von 1 Stunde vor dem Erfassungszeitpunkt des Transformatormesswerts bis 2 Stunden nach dem Erfassungszeitpunkt des Transformatormesswerts reicht. Bei anderen Beispielen kann der Zeitbereich 30 Minuten vor dem Erfassungszeitpunkt des Transformatormesswerts beginnen und 90 Minuten nach dem Erfassungszeitpunkt des Transformatormesswerts enden. Bei noch einem anderen Beispiel kann der Zeitbereich 15 Minuten vor dem Erfassungszeitpunkt des Transformatormesswerts beginnen und 60 Minuten nach dem Erfassungszeitpunkt des Transformatormesswerts enden. Dadurch können voraussichtlich fehlerhafte Transformatormesswerte zuverlässig als nicht-plausibel bewertet werden und bei der Bestimmung des Überwachungsergebnisses unberücksichtigt bleiben. Indem ein verhältnismäßig großer Zeitbereich vorgegeben wird, in welchem Transformatormesswerte aufgrund von Feuchtigkeit unberücksichtigt bleiben, können zum Beispiel Trocknungszeiten nach einem Regenschauer oder einsetzende Kondensation bei plötzlich eintreffender feuchtwarmer Luft zuverlässig berücksichtigt werden.

Der Feuchtigkeitssensor kann beispielsweise einen Regensensor umfassen. Die Feuchtigkeitsmesswertinformation zeigt in diesem Fall an, ob zu einem Messzeitpunkt Niederschlag am Ort des Feuchtigkeitssensors vorliegt. Der Niederschlag kann beispielsweise flüssiger Niederschlag in Form von Regen oder Betauung umfassen. Andere Niederschlagsarten, wie zum Beispiel Schnee oder Hagel, können ebenfalls erfasst und entsprechend berücksichtigt werden.

In einer Ausführungsform der Erfindung kann vorzugsweise ein Teil der Transformatormesswertinformation, zum Beispiel einige Transformatormesswerte, beim Erzeugen des Überwachungsergebnisses unberücksichtigt bleiben, wenn die Feuchtigkeitsmesswertinformation anzeigt, dass zu dem Messzeitpunkt Niederschlag am Ort des Fertigkeitssensors vorliegt. Der Feuchtigkeitssensor kann beispielsweise anzeigen, dass zu dem Messzeitpunkt Niederschlag am Ort des Feuchtigkeitssensors vorliegt, wenn eine Sensorfläche des Feuchtigkeitssensors mit Flüssigkeit benetzt ist, d. h., der Flüssigkeitssensor kann beispielsweise nur die Werte trocken oder feucht liefern. Alternativ oder zusätzlich kann der Flüssigkeitssensor beispielsweise eine Niederschlagsmenge anzeigen, welche in einem bestimmten vorangegangenen Zeitraum gefallen ist, beispielsweise in Millimetern pro Stunde. Der oben genannte vorbestimmte Zeitbereich für die Zuordnung von Feuchtigkeitsmesswerten zu Transformatormesswerten kann beispielsweise in Abhängigkeit von der Niederschlagsmenge eingestellt werden.

Alternativ oder zusätzlich kann der Feuchtigkeitssensor einen Luftfeuchtigkeitssensor umfassen. In diesem Fall zeigt die Feuchtigkeitsmesswertinformation die Luftfeuchtigkeit zu einem Messzeitpunkt am Ort des Feuchtigkeitssensors an.

In einer Ausführungsform der Erfindung kann vorzugsweise zumindest ein Teil der Transformatormesswertinformation beim Erzeugen des Überwachungsergebnisses nicht berücksichtigt werden, wenn die Feuchtigkeitsmesswertinformation anzeigt, dass zu einem Messzeitpunkt die Luftfeuchtigkeit über einem vorgegebenen Luftfeuchtigkeitsschwellenwert liegt. Somit können beispielsweise Transformatormesswerte, welche bei extrem hoher Luftfeuchtigkeit erfasst wurden, bei der Erzeugung des Überwachungsergebnisses ausgeschlossen werden. Bei extrem hoher Luftfeuchtigkeit, beispielsweise bei über 90 % oder über 95 % oder sogar über 99 %, kann Kondensation an beispielsweise den Durchführungen auftreten, wodurch die Transformatormesswerte verfälscht werden können.

Die Feuchtigkeitsmesswertinformation kann alternativ oder zusätzlich zu mehreren zeitlich aufeinanderfolgenden Messzeitpunkten die Luftfeuchtigkeit am Ort des Feuchtigkeitssensors anzeigen. Zumindest ein Teil der Transformatormesswertinformation wird beim Erzeugen des Überwachungsergebnisses nicht berücksichtigt, wenn ein zeitlicher Gradient der Luftfeuchtigkeit über einem vorgegebenen Luftfeuchtigkeitsänderungsschwellenwert liegt. Bei einer raschen Erhöhung der Luftfeuchtigkeit, zum Beispiel wenn plötzlich warme feuchte Luft an den Ort der Transformatorvorrichtung getrieben wird, kann Betauung an Komponenten der Transformatorvorrichtung, beispielsweise an den Leitungsdurchführungen, auftreten und so zu einer Verfälschung der Transformatormesswerte führen. Indem Transformatormesswerte in dieser Situation bei der Erzeugung des Überwachungsergebnisses nicht berücksichtigt werden, kann die Qualität des Überwachungsergebnisses verbessert werden.

Ein Überwachungssystem für einen Transformator umfasst eine Messvorrichtung, einen Feuchtigkeitssensor und eine Auswerteschaltung. Die Messvorrichtung ist ausgestaltet, eine Transformatormesswertinformation bereitzustellen, welche eine zu überwachende elektrische Eigenschaft der Transformatorvorrichtung anzeigt. Der Feuchtigkeitssensor ist ausgestaltet, eine Feuchtigkeitsmesswertinformation bereitzustellen, welche eine Feuchtigkeit am Ort der Transformatorvorrichtung anzeigt. Die Auswerteschaltung ist mit der Messvorrichtung und dem Feuchtigkeitssensor gekoppelt und ausgestaltet, ein Überwachungsergebnis für die Transformatorvorrichtung in Abhängigkeit von der Transformatormesswertinformation und der Feuchtigkeitsmesswertinformation zu erzeugen, wobei die Auswerteschaltung derart ausgestaltet ist, dass sie in Abhängigkeit von der Feuchtigkeitsmesswertinformation zumindest einen Teil der Transformatormesswertinformation beim Erzeugen des Überwachungsergebnisses nicht berücksichtigt
Das Überwachungssystem kann zur Durchführung des zuvor beschriebenen Verfahrens ausgestaltet sein und umfasst daher auch die Vorteile und Eigenschaften des Verfahrens, welche zuvor beschrieben wurden.

### KURZE BESCHREIBUNG DER FIGUREN

Die vorliegende Erfindung wird nachfolgend unter Bezugnahme auf die Zeichnungen anhand von Ausführungsformen erläutert werden.
Fig. 1 zeigt schematisch eine Transformatorvorrichtung in Verbindung mit einem Überwachungssystem gemäß einer Ausführungsform der vorliegenden Erfindung.
Fig. 2 zeigt ein Ablaufdiagramm mit Verfahrensschritten eines Verfahrens zum automatischen Überwachen einer Transformatorvorrichtung gemäß einer Ausführungsform der vorliegenden Erfindung.
Fig. 3 zeigt schematisch einen Verlauf eines Verlustfaktors einer Transformatorvorrichtung sowie eine Niederschlagsmenge über der Zeit.
Fig. 4 zeigt schematisch einen Verlauf eines Verlustfaktors einer Transformatorvorrichtung sowie eine relative Luftfeuchtigkeit über der Zeit.

### DETAILLIERTE BESCHREIBUNG VON AUSFÜHRUNGSBEISPIELEN

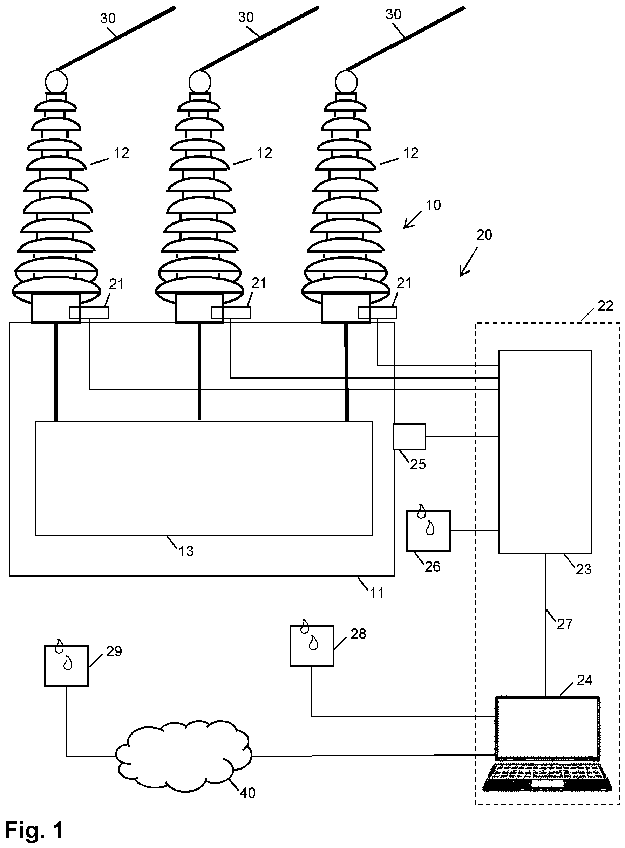

Fig. 1 zeigt eine Transformatorvorrichtung 10 in Verbindung mit einem Überwachungssystem 20 zur automatischen Überwachung der Transformatorvorrichtung 10. Die Transformatorvorrichtung 10 kann beispielsweise einen Leistungstransformator für ein Hochspannungsnetz umfassen. Die Transformatorvorrichtung 10 kann beispielsweise im Freien, beispielsweise in einem Umspannwerk, angeordnet sein. Die Transformatorvorrichtung 10 umfasst einen Transformatorkessel 11, in welchem ein Transformator 13 angeordnet ist. Der Transformator 13 kann beispielsweise ein Dreiphasentransformator sein, welcher mit drei Phasen eines Hochspannungsnetzes gekoppelt ist. Dazu umfasst die Transformatorvorrichtung 10 beispielsweise drei Leitungsdurchführungen 12. Über die drei Leitungsdurchführungen 12 können beispielsweise Oberspannungswicklungen des Transformators 13 mit entsprechenden Hochspannungsleitungen 30 des Hochspannungsnetzes gekoppelt werden. Die Transformatorvorrichtung 10 kann weitere Leitungsdurchführungen aufweisen, welche in der Fig. 1 nicht gezeigt sind, beispielsweise eine Leitungsdurchführung für einen Mittelpunktleiter der Oberspannungswicklungen des Transformators 13 oder weitere Leitungsdurchführungen für eine Unterspannungswicklung des Transformators 13.

Das Überwachungssystem 20 umfasst Durchführungsadapter 21. Beispielsweise kann an jeder der Leitungsdurchführungen 12 ein jeweiliger Durchführungsadapter 21 vorgesehen sein. Die Durchführungsadapter 21 ermöglichen beispielsweise eine synchrone Erfassung von Signalen für Kapazität, Verlustfaktor, transienten Überspannungen und/oder Teilentladungen an den Leitungsdurchführungen 12. Das Überwachungssystem 20 umfasst weiterhin eine Auswerteschaltung 22, welche beispielsweise eine Datenerfassungseinheit 23 in der Nähe des Transformatorkessels 11 und eine Datenverarbeitungsvorrichtung 24 in größerer Entfernung von dem Transformatorkessel 11 umfasst. Die Datenverarbeitungsvorrichtung 24 ist beispielsweise über eine Kommunikationsverbindung 27 mit der Datenerfassungseinheit 23 gekoppelt. Die Kommunikationsverbindung 27 kann beispielsweise als Glasfaserverbindung realisiert sein. Die Kommunikationsverbindung 27 kann mehrere 100 m oder sogar einige Kilometer lang sein, sodass die Datenverarbeitungsvorrichtung 24 außerhalb eines Gefahren- und Störbereichs der Transformatorvorrichtung 10 angeordnet werden kann. Die Datenverarbeitungsvorrichtung 24 kann beispielsweise einen zentralen Computer mit einer Überwachungssoftware umfassen. Die Datenverarbeitungsvorrichtung 24 kann beispielsweise mit weiteren Datenerfassungseinheiten, welche weiteren Transformatorvorrichtungen zugeordnet sind, über entsprechende Kommunikationsverbindungen verbunden sein. Die Datenverarbeitungsvorrichtung 24 kann jedoch auch in der Nähe der Datenerfassungseinheit 23 angeordnet sein oder als integrierte Einheit mit der Datenerfassungseinheit 23 ausgebildet sein.

Die Durchführungsadapter 21 sind mit der Datenerfassungseinheit 23 der Auswerteschaltung 22 gekoppelt. Die Datenerfassungseinheit 23 kann mehrere Eingänge zur Erfassung der Daten von den Durchführungsadaptern 21 aufweisen. Die Datenerfassungseinheit 23 kann weitere Eingänge umfassen, beispielsweise einen Eingang für einen UHF-Sensor 25, welcher beispielsweise an der Transformatorvorrichtung 10 vorgesehen ist, um Messsignale von Teilentladungen im Transformator 11 bereitzustellen. Weiterhin kann das Überwachungssystem 20 einen Feuchtigkeitssensor 26 umfassen, welcher mit der Auswerteschaltung 22 gekoppelt ist. Beispielsweise kann der Feuchtigkeitssensor 26 mit der Datenerfassungseinheit 23 gekoppelt sein. Der Feuchtigkeitssensor 26 kann eine Feuchtigkeitsmesswertinformation erfassen, welche eine Feuchtigkeit am Ort der Transformatorvorrichtung 10 anzeigt. Alternativ oder zusätzlich kann ein Feuchtigkeitssensor 28 vorgesehen sein, welcher eine Feuchtigkeitsmesswertinformation am Ort der Transformatorvorrichtung 10 erfasst und mit der Datenverarbeitungsvorrichtung 24 gekoppelt ist. In einem weiteren Beispiel kann ein Feuchtigkeitssensor 29 vorgesehen sein, welcher über ein Kommunikationsnetz 40, beispielsweise das Internet, mit der Datenverarbeitungsvorrichtung 24 gekoppelt ist und ausgestaltet ist, eine Feuchtigkeitsmesswertinformation bezüglich der Feuchtigkeit am Ort der Transformatorvorrichtung 10 bereitzustellen. Der Feuchtigkeitssensor 29 kann beispielsweise Bestandteil eines Wettervorhersagesystems sein, welches unabhängig dem Überwachungssystem 20 betrieben wird und über beispielsweise das Internet 40 Informationen bezüglich der Feuchtigkeit am Ort der Transformatorvorrichtung 10 bereitstellt.

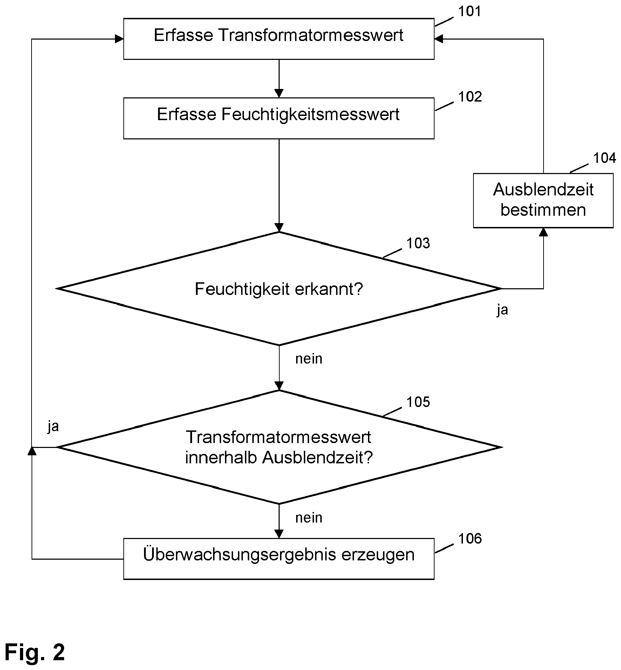

Ein beispielhafter Betrieb des Überwachungssystems 20 wird nachfolgend unter Bezugnahme auf die Fig. 2 im Detail beschrieben werden. Fig. 2 zeigt Verfahrensschritte 101 bis 106, welche von der Auswerteschaltung 22 ausgeführt werden können.

Das Überwachungssystem 20 kann beispielsweise verwendet werden, um eine Änderung eines Verlustfaktors oder eine Veränderung einer Verlustkapazität an den Leitungsdurchführungen 12 der Transformatorvorrichtung 10 anzuzeigen, zu erkennen und/oder zu überwachen. Insbesondere bei Transformatorvorrichtungen, welche einen Hochspannungstransformator umfassen, beispielsweise einen Hochspannungstransformator, welcher bei mehreren 10 kV oder mehreren 100 kV betrieben wird, ist die Überwachung des Verlustfaktors oder der Verlustkapazität wichtig, um Störungen an dem Transformator frühzeitig zu erkennen. Der Verlustfaktor, welcher auch als Tangens Delta, tan Δ, bezeichnet wird, sowie die Verlustkapazität sind einem Fachmann bekannt. Messgrößen zur Bestimmung des Verlustfaktors und der Verlustkapazität können beispielsweise mithilfe von Durchführungsadaptern 21 an den Leitungsdurchführungen 12 erfasst werden und in der Datenerfassungseinheit 23 bestimmt werden. Eine Änderung des Verlustfaktors bzw. der Verlustkapazität an den Leitungsdurchführungen 12 ist meist ein langfristiger Prozess, welcher beispielsweise auf Alterung beruht. Aus diesem Grunde ist es prinzipiell nicht erforderlich, stündlich oder noch häufiger Messwerte zu erfassen, um den Verlustfaktor oder die Verlustkapazität zu bestimmen. Äußere Einflüsse, beispielsweise Feuchtigkeit und Regen, insbesondere in Verbindung mit Staub, können die Messwerte jedoch beeinflussen. Dies betrifft insbesondere Transformatorvorrichtungen 10, welche im Freien und im Wesentlichen ungeschützt angeordnet sind.

Das Verfahren, welches nachfolgend unter Bezugnahme auf die Fig. 2 beschrieben werden wird, berücksichtigt diese äußeren Einflüsse, indem eine Transformatormesswertinformation, welche eine zu überwachende elektrische Eigenschaft der Transformatorvorrichtung 10 anzeigt, mit einer Messvorrichtung, beispielsweise den Durchführungsadaptern 21, erfasst wird und zusätzlich eine Feuchtigkeitsmesswertinformation mit einem Feuchtigkeitssensor, beispielsweise einem der Sensoren 26, 28 oder 29, erfasst wird. Die Feuchtigkeitsmesswertinformation zeigt eine Feuchtigkeit am Ort der Transformatorvorrichtung 10 an. Beispielsweise kann die Feuchtigkeitsmesswertinformation eine Feuchtigkeit in einer Umgebung der Transformatorvorrichtung anzeigen. Dazu kann ein entsprechender Feuchtigkeitssensor 26, 28 oder 29 in der Umgebung der Transformatorvorrichtung 10 im Freien angeordnet werden, beispielsweise in einem Umkreis von weniger als 100 m, vorzugsweise weniger als 20 m oder sogar weniger als 5 m. Mit der Auswerteschaltung 22 wird ein Überwachungsergebnis für die Transformatorvorrichtung 10 in Abhängigkeit von der Transformatormesswertinformation und der Feuchtigkeitsmesswertinformation erzeugt, indem in Abhängigkeit von der Feuchtigkeitsmesswertinformation zumindest ein Teil der Transformatormesswertinformation beim Erzeugen des Überwachungsergebnisses nicht berücksichtigt wird. Dadurch können Fehler in dem Überwachungsergebnis, welche durch Regen oder Feuchtigkeit hervorgerufen werden, vermieden werden.

Im Detail wird im Schritt 101 die Transformatormesswertinformation erfasst. Beispielsweise können an den Durchführungsadaptern 21 Signale erfasst werden und zu der Datenerfassungseinheit 23 übertragen werden, aus denen die Datenerfassungseinheit 23 beispielsweise einen aktuellen Verlustfaktor oder mehrere aktuelle Verlustfaktoren, beispielsweise einen Verlustfaktor für jede Phase der Transformatorvorrichtung 10, bestimmt. Im Schritt 102 wird die Feuchtigkeitsmesswertinformation beispielsweise mithilfe des Feuchtigkeitssensors 26 erfasst und zu der Datenerfassungseinheit 23 übertragen. Alternativ oder zusätzlich können Feuchtigkeitsmesswertinformationen der Feuchtigkeitssensoren 28 und/oder 29 zu der Datenverarbeitungsvorrichtung 24 übertragen werden. Der aktuelle Verlustfaktor sowie die aktuelle Feuchtigkeitsmesswertinformation von dem Feuchtigkeitssensor 26 wird über die Datenverbindung 27 zu der Datenverarbeitungsvorrichtung 24 übertragen.

Alternativ oder zusätzlich kann die Datenerfassungseinheit 23 mehrere Verlustfaktoren, welche zeitlich aufeinanderfolgend bestimmt wurden, sammeln und an die Datenverarbeitungsvorrichtung 24 übertragen. Dazu können die Verlustfaktoren jeweils mit einem entsprechenden Zeitstempel versehen werden. Auf gleiche Art und Weise kann die Datenerfassungseinheit 23 Feuchtigkeitsmesswerte des Feuchtigkeitssensor 26, welche zeitlich aufeinanderfolgende bestimmt wurden, sammeln und an die Datenverarbeitungsvorrichtung 24 übertragen, wobei die einzelnen Feuchtigkeitsmesswerte jeweils mit einem entsprechenden Zeitstempel versehen werden. In der Datenverarbeitungsvorrichtung 24 werden zeitlich korrelierte Feuchtigkeitsmesswerte den entsprechenden Verlustfaktoren zugeordnet. In Abhängigkeit davon, ob Feuchtigkeit erkannt wurde, werden die entsprechenden zugeordneten Verlustfaktoren als plausibel oder nicht-plausibel bewertet. Dabei können folgende Überlegungen berücksichtigt werden.

Wettereffekte können sehr unterschiedlich sein und es ist daher schwierig, eine genaue Vorhersage zu treffen, ob ein Transformatormesswert, beispielsweise ein Verlustfaktor, durch die aktuelle Wettersituation beeinflusst wird oder nicht. Das Vorhandensein von Regen ist ein verhältnismäßig zuverlässiger Indikator. Daher kann die Datenverarbeitungsvorrichtung 24 beispielsweise alle Transformatormesswerte als nicht-plausibel bewerten, welche zu einem Zeitpunkt erfasst wurden, zu welchem die Feuchtigkeitsmesswerte Regen am Ort der Transformatorvorrichtung 10 anzeigen. Um eventuelle Ungenauigkeiten zu vermeiden, kann ein Sicherheitszeitbereich um diese Bewertung gelegt werden. Zum Beispiel kann es vorkommen, dass der Regen vorbei ist, aber die Oberfläche der Leitungsdurchführung 12 noch feucht ist. Die Datenverarbeitungsvorrichtung 24 kann daher auch Transformatormesswerte als nicht-plausibel bewerten, welche in einem vorbestimmten Zeitraum nach dem Ende des Regens erfasst wurden.

Ein derartiges Berücksichtigen oder Nicht-Berücksichtigen von Messwerten in einem Zeitbereich um einen Erfassungszeitpunkt eines anderen Messwerts und in Abhängigkeit von diesem anderen Messwert wird als Gating bezeichnet. Der Zeitbereich, in welchem Messwerte nicht berücksichtigt werden, wird als Gating-Time oder Ausblendzeit bezeichnet.

Bei dem vorliegenden Verfahren entspricht der Zeitbereich, in welchem die Transformatormesswerte als nicht-plausibel bewertet werden und somit nicht berücksichtigt werden, einer solchen Ausblendzeit. Die Ausblendzeit umfasst somit beispielsweise den Zeitpunkt, zu welchem Regen erfasst wurde und einen vorgegebenen Zeitraum danach, beispielsweise einige Minuten bis einige Stunden, beispielsweise 30 Minuten bis 2 Stunden. Die Ausblendzeit kann auch einen Zeitraum vor dem Zeitpunkt, zu welchem Regen erfasst wurde, umfassen, um beispielsweise den geografischen Abstand zwischen dem Feuchtigkeitssensor 26 und der Transformatorvorrichtung 10 zu berücksichtigen. Beispielsweise kann die Ausblendzeit bereits einige Minuten, beispielsweise 15 bis 60 Minuten vor dem Zeitpunkt, zu welchem Regen erfasst wurde, beginnen.

In dem im Fig. 2 gezeigten Verfahren wird daher im Schritt 103 festgestellt, ob der Feuchtigkeitssensor 26 (oder einer der Feuchtigkeitssensoren 28 oder 29) Regen erkannt hat. Wird im Schritt 103 festgestellt, dass der Feuchtigkeitssensoren 26 Regen erkannt hat, wird eine Ausblendzeit im Schritt 104 festgelegt und der aktuelle Transformatormesswert als nicht-plausibel bewertet und bei der Erzeugung eines Überwachungsergebnisses nicht weiter berücksichtigt. Das Verfahren wird daher im Schritt 101 fortgesetzt.

Falls kein Regen erkannt wurde, wird im Schritt 105 überprüft, ob der aktuelle Transformatormesswert innerhalb einer (zuvor im Schritt 104 bestimmten) Ausblendzeit liegt. Sofern dies nicht der Fall ist, geht der aktuelle Transformatormesswert im Schritt 106 in das Überwachungsergebnis ein.

Das Verfahren kann kontinuierlich mit dem Schritt 101 fortgesetzt werden. Liegt der aktuelle Transformatormesswert innerhalb einer Ausblendzeit (Schritt 105) so wird dieser Transformatormesswert als nicht-plausibel bewertet und geht nicht in die Erzeugung des Überwachungsergebnisses ein.

Neben Regen, also Feuchtigkeit in Form eines feuchten Niederschlags, kann auch Luftfeuchtigkeit die Bestimmung des Verlustfaktors beeinträchtigen, beispielsweise durch Betauung an den Leitungsdurchführungen 12 oder Kondensatbildung in der Luft (zum Beispiel Nebel) um die Leitungsdurchführungen 12 herum. Dementsprechend kann der Feuchtigkeitssensor 26 (oder der Feuchtigkeitssensor 28 oder 29) als Feuchtigkeitsmesswert auch die Luftfeuchtigkeit am Ort der Transformatorvorrichtung 10 anzeigen, beispielsweise die relative Luftfeuchtigkeit oder die absolute Luftfeuchtigkeit. Transformatormesswerte können beispielsweise als nicht-plausibel bewertet werden, wenn beispielsweise eine sehr hohe Luftfeuchtigkeit vorliegt oder aufgrund eines raschen Anstiegs der Luftfeuchtigkeit eine Betauung oder sonstige Kondensatbildung im Bereich der Leitungsdurchführungen 12 zu erwarten ist. Daher kann beispielsweise im Schritt 103 zusätzlich eine Neigung einer Luftfeuchtigkeitskurve bestimmt werden, und eine entsprechende Ausblendzeit bestimmt werden, wenn die Luftfeuchtigkeitskurve eine bestimmte Neigung aufweist, insbesondere wenn ein steiler Anstieg der Luftfeuchtigkeit festgestellt wird. Wie zuvor beschrieben, können dann im Schritt 105 Transformatormesswerte innerhalb der Ausblendzeit als nicht-plausibel bewertet werden und bei der Erzeugung des Überwachungsergebnisses unberücksichtigt bleiben.

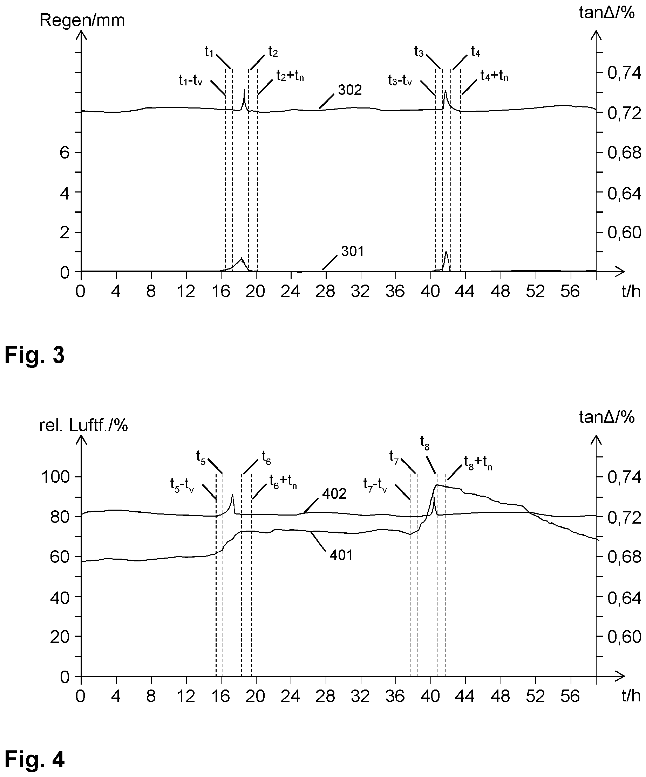

Fig. 3 zeigt schematisch einen Graph 301, welcher Feuchtigkeitsmesswerte als Regen in Millimetern pro Zeiteinheit (z.B. pro Stunde) über der Zeit anzeigt. Fig. 3 zeigt ferner schematisch einen Graph 302, welcher Transformatormesswerte als Verlustfaktor in Prozent über der Zeit anzeigt. In dem gezeigten Beispiel setzt zum Zeitpunkt t₁ Regen ein. Die Ausblendzeit, während derer Transformatormesswerte 302 als nicht-plausibel bewertet werden und daher nicht in die Erzeugung des Überwachungsergebnisses für die Transformatorvorrichtung 10 eingehen, ist beispielsweise so definiert, dass sie eine vorgegebene Zeit tᵥ vor dem Beginn des Regens einsetzt. Die Ausblendzeit beginnt somit bei t₁-tᵥ. Der Regen endet beispielsweise zum Zeitpunkt t₂. Die Ausblendzeit ist beispielsweise so definiert, dass sie erst eine vorgegebene Zeit tₙ nach dem Ende des Regens endet, also zum Zeitpunkt t₂+tₙ. Transformatormesswerte zwischen t₁-tᵥ und t₂+tₙ werden daher bei der Erzeugung des Überwachungsergebnisses für die Transformatorvorrichtung 10 nicht berücksichtigt. Der Anstieg des Verlustfaktors, welcher sich im Bereich zwischen t₁-tᵥ und t₂+tₙ befindet, wird daher zuverlässig bei der Erzeugung des Überwachungsergebnisses für die Transformatorvorrichtung 10 ausgeschlossen. Im weiteren Verlauf setzt zum Zeitpunkt ts wieder Regen ein, welcher zum Zeitpunkt t₄ wieder aufhört. Wie aus Fig. 3 ersichtlich ist, ist zum Zeitpunkt t₄ der Verlustfaktor noch deutlich erhöht gegenüber der regenfreien Zeit davor. Indem die Ausblendzeit bereits zum Zeitpunkt t₃-tᵥ beginnt und erst zum Zeitpunkt t₄+tₙ endet, können jedoch die Verlustfaktorwerte, welche vermutlich lediglich aufgrund des Regens erhöhte Werte anzeigen, zuverlässig bei der Erzeugung des Überwachungsergebnisses für die Transformatorvorrichtung 10 ausgeschlossen werden.

Fig. 4 zeigt schematisch einen Graph 401, welcher Feuchtigkeitsmesswerte als relative Luftfeuchtigkeit in Prozent über der Zeit anzeigt. Fig. 4 zeigt ferner schematisch einen Graph 402, welcher Transformatormesswerte als Verlustfaktor in Prozent über der Zeit anzeigt. In dem Beispiel der Fig. 4 steigt die Luftfeuchtigkeit zwischen Stunde 14 und Stunde 20 an. Insbesondere im Zeitbereich zwischen ts und ts steigt die Luftfeuchtigkeit verhältnismäßig schnell an, sodass die Neigung der Kurve 401 in diesem Bereich besonders steil ist. Ein entsprechender Schwellenwert für die Steigung der Kurve kann in der Datenverarbeitungsvorrichtung 24 vorgesehen sein, welcher eine Steigung als kritisch für beispielsweise Betauung an den Leitungsdurchführungen 12 bewertet. Bei der Bewertung der Steigung der Luftfeuchtigkeitskurve 401 können weitere Messwerte berücksichtigt werden, beispielsweise eine Lufttemperatur am Ort der Transformatorvorrichtung 10, sowie ein Luftdruck und eine Temperatur der Leitungsdurchführungen 12 selbst. In dem Beispiel der Fig. 4 übersteigt die Steigung des Graphen 401 der Luftfeuchtigkeit im Zeitbereich zwischen t₅ und t₆ den vorgegebenen Schwellenwert. Eine Ausblendzeit kann wie zuvor unter Bezugnahme auf Fig. 3 beschrieben wurde definiert sein. Die Ausblendzeit beginnt daher zum Zeitpunkt t₅-tᵥ und endet zum Zeitpunkt t₆+tₙ. Transformatormesswerte im Zeitbereich zwischen t₅-tᵥ und t₆+tₙ werden als nicht-plausibel gewertet und bleiben bei der Erzeugung des Überwachungsergebnisses für die Transformatorvorrichtung 10 unberücksichtigt. Nach dem Zeitpunkt t₆+tₙ ist die Luftfeuchtigkeit zwar erheblich höher als vor dem Zeitpunkt t₅-tᵥ, ändert sich jedoch nur verhältnismäßig langsam, sodass Transformatormesswerte nach t₆+tₙ als plausibel bewertet werden und daher bei der Erzeugung des Überwachungsergebnisses für die Transformatorvorrichtung 10 berücksichtigt werden. Zum Zeitpunkt t₇ steigt die Luftfeuchtigkeit ein weiteres Mal bis zum Zeitpunkt ts rasch an, sodass die Steigung der Luftfeuchtigkeitskurve den vorgegebenen Schwellenwert überschreitet. Eine entsprechende Ausblendzeit wird von t₇-tᵥ bis t₈+tₙ eingestellt und Transformatormesswerte in dieser Ausblendzeit als nicht-plausibel gewertet und daher bei der Erzeugung des Überwachungsergebnisses für die Transformatorvorrichtung 10 nicht berücksichtigt.

Die Berücksichtigung von Regen, wie es zuvor in Verbindung mit Fig. 3 beschrieben wurde, und die Berücksichtigung von Luftfeuchtigkeit, wie es zuvor in Verbindung mit Fig. 4 beschrieben wurde, können miteinander kombiniert werden. Beispielsweise können Ausblendzeiten, welche aufgrund von Regen oder Feuchtigkeit eingestellt werden, miteinander kombiniert werden, indem die Ausblendzeiten überlappend verwendet werden, sodass Transformatormesswerte als nicht-plausibel bewertet werden, sobald sie in mindestens eine der Ausblendzeiten aufgrund von Regen oder Luftfeuchtigkeit fallen.

Um sicherzustellen, dass auch Transformatormesswerte, welche beispielsweise vor dem Beginn des Regens oder vor dem steilen Anstieg der Luftfeuchtigkeit erfasst wurden und innerhalb der daraus resultierenden Ausblendzeit liegen, als nicht-plausibel bewertet werden und somit bei der Erzeugung des Überwachungsergebnisses für die Transformatorvorrichtung 10 nicht berücksichtigt werden, können die Feuchtigkeitsmesswerte und die Transformatormesswerte beispielsweise in einem Speicher zwischengespeichert werden und erst nach Ablauf einer vorbestimmten Zeit, beispielsweise der Zeit tᵥ, für die Bewertung der Transformatormesswerte als plausibel oder nicht-plausibel herangezogen werden.

Das Überwachungsergebnis für die Transformatorvorrichtung 10 kann beispielsweise als Graph auf einer Anzeigevorrichtung der Datenverarbeitungsvorrichtung 24 dargestellt werden, wobei Bereiche der Ausblendzeit markiert werden, beispielsweise farblich oder ausgegraut. Warnungen, welche aufgrund eines Anstiegs des Verlustfaktors innerhalb der Ausblendzeit erzeugt werden, können unterdrückt oder zumindest als wahrscheinlich fehlerhaft gekennzeichnet werden. Dadurch kann eine Qualität des Überwachungsergebnisses für die Transformatorvorrichtung 10 verbessert werden.

## Patentansprüche

1. Verfahren zum automatischen Überwachen einer Transformatorvorrichtung, umfassend:
- Erfassen (101) einer Transformatormesswertinformation, welche eine zu überwachende elektrische Eigenschaft der Transformatorvorrichtung (10) anzeigt, mit einer Messvorrichtung (21),
- Erfassen (102) einer Feuchtigkeitsmesswertinformation mit einem Feuchtigkeitssensor (26, 27, 28), wobei die Feuchtigkeitsmesswertinformation eine Feuchtigkeit am Ort der Transformatorvorrichtung (10) anzeigt, und
- Erzeugen (106), mit einer Auswerteschaltung (22), eines Überwachungsergebnisses für die Transformatorvorrichtung (10) in Abhängigkeit von der Transformatormesswertinformation und der Feuchtigkeitsmesswertinformation,
**dadurch gekennzeichnet,**
**dass** in Abhängigkeit von der Feuchtigkeitsmesswertinformation zumindest ein Teil der Transformatormesswertinformation beim Erzeugen (106) des Überwachungsergebnisses nicht berücksichtigt wird.

2. Verfahren nach Anspruch 1, wobei die Transformatormesswertinformation mehrere zeitlich nacheinander erfasste Transformatormesswerte umfasst, wobei das Verfahren umfasst:
- Bewerten eines Transformatormesswerts der mehreren Transformatormesswerte in Abhängigkeit von der Feuchtigkeitsmesswertinformation als plausibel oder nicht-plausibel, und
- Erzeugen (106) des Überwachungsergebnisses unabhängig von dem Transformatormesswert, wenn der Transformatormesswert als nicht-plausibel bewertet ist.

3. Verfahren nach Anspruch 2, wobei die Feuchtigkeitsmesswertinformation mehrere zeitlich nacheinander erfasste Feuchtigkeitsmesswerte umfasst, wobei das Verfahren umfasst:
Zuordnen von mindestens einem zeitlich korrelierten Feuchtigkeitsmesswert der mehreren Feuchtigkeitsmesswerte zu einem Transformatormesswert der mehreren Transformatormesswerte, und
Bewerten des Transformatormesswerts als plausibel oder nicht-plausibel in Abhängigkeit von dem zugeordneten mindestens einen Feuchtigkeitsmesswert.

4. Verfahren nach Anspruch 3, wobei das Zuordnen von mindestens einem zeitlich korrelierten Feuchtigkeitsmesswert umfasst:
Zuordnen von mindestens einem Feuchtigkeitsmesswert der mehreren Feuchtigkeitsmesswerte, welcher in einem vorgegebenen Zeitbereich in Bezug auf einen Erfassungszeitpunkt eines Transformatormesswerts erfasst wurde, zu dem Transformatormesswert,
wobei vorzugsweise der vorgegebene Zeitbereich von einem ersten Zeitpunkt vor dem Erfassungszeitpunkt des Transformatormesswerts bis zu einem zweiten Zeitpunkt nach dem Erfassungszeitpunkt des Transformatormesswerts reicht.

5. Verfahren nach einem der vorhergehenden Ansprüche,
wobei der Feuchtigkeitssensor (26, 28, 29) einen Regensensor umfasst, wobei die Feuchtigkeitsmesswertinformation anzeigt, ob zu einem Messzeitpunkt Niederschlag am Ort des Feuchtigkeitssensors (26, 28, 29) vorliegt,
wobei vorzugsweise zumindest ein Teil der Transformatormesswertinformation beim Erzeugen des Überwachungsergebnisses nicht berücksichtigt wird, wenn die Feuchtigkeitsmesswertinformation anzeigt, dass zu dem Messzeitpunkt Niederschlag am Ort des Feuchtigkeitssensors (26, 28, 29) vorliegt.

6. Verfahren nach einem der vorhergehenden Ansprüche,
wobei der Feuchtigkeitssensor (26, 28, 29) einen Luftfeuchtigkeitssensor umfasst, wobei die Feuchtigkeitsmesswertinformation zu einem Messzeitpunkt die Luftfeuchtigkeit am Ort des Feuchtigkeitssensors (26, 28, 29) anzeigt,
wobei vorzugsweise zumindest ein Teil der Transformatormesswertinformation beim Erzeugen des Überwachungsergebnisses nicht berücksichtigt wird, wenn die Feuchtigkeitsmesswertinformation anzeigt, dass zu dem Messzeitpunkt die Luftfeuchtigkeit über einem vorgegeben Luftfeuchtigkeitsschwellenwert liegt.

7. Verfahren nach Anspruch 6,
wobei die Feuchtigkeitsmesswertinformation zu mehreren zeitlich aufeinanderfolgenden Messzeitpunkten die Luftfeuchtigkeit am Ort des Feuchtigkeitssensors (26, 28, 29) anzeigt,
wobei zumindest ein Teil der Transformatormesswertinformation beim Erzeugen des Überwachungsergebnisses nicht berücksichtigt wird, wenn ein Gradient der Luftfeuchtigkeit über der Zeit über einem vorgegeben Luftfeuchtigkeitsänderungsschwellenwert liegt.

8. Verfahren nach einem der vorhergehenden Ansprüche, wobei die Transformatorvorrichtung (10) im Freien auf einer Landfläche angeordnet ist.

9. Verfahren nach einem der vorhergehenden Ansprüche, wobei die Transformatorvorrichtung (10) einen Hochspannungstransformator (13) umfasst.

10. Verfahren nach einem der vorhergehenden Ansprüche, wobei die Transformatorvorrichtung (10) einen Transformator (13) und Leitungsdurchführungen (12) für Leitungen (30) zu dem Transformator (13) umfasst.

11. Verfahren nach einem der vorhergehenden Ansprüche, wobei die Transformatormesswertinformation einen Verlustfaktor der Transformatorvorrichtung (10) umfasst.

12. Verfahren nach einem der vorhergehenden Ansprüche, wobei der Feuchtigkeitssensor (26, 28, 29) in einer Umgebung der Transformatorvorrichtung (10) im Freien angeordnet ist.

13. Überwachungssystem für eine Transformatorvorrichtung, umfassend:
- eine Messvorrichtung (21), welche ausgestaltet ist, eine Transformatormesswertinformation, welche eine zu überwachende elektrische Eigenschaft der Transformatorvorrichtung (10) anzeigt, bereitzustellen,
- einen Feuchtigkeitssensor (26, 28, 29), welcher ausgestaltet ist, eine Feuchtigkeitsmesswertinformation bereitzustellen, wobei die Feuchtigkeitsmesswertinformation eine Feuchtigkeit am Ort der Transformatorvorrichtung (10) anzeigt, und
- eine Auswerteschaltung (22), welche mit der Messvorrichtung (21) und dem Feuchtigkeitssensor (26, 28, 29) gekoppelt ist und ausgestaltet ist, ein Überwachungsergebnis für die Transformatorvorrichtung (10) in Abhängigkeit von der Transformatormesswertinformation und der Feuchtigkeitsmesswertinformation zu erzeugen,
**dadurch gekennzeichnet,**
**dass** die Auswerteschaltung (22) derart ausgestaltet ist, dass sie in Abhängigkeit von der Feuchtigkeitsmesswertinformation zumindest einen Teil der Transformatormesswertinformation beim Erzeugen (106) des Überwachungsergebnisses nicht berücksichtigt.

14. Überwachungssystem nach Anspruch 13, wobei das Überwachungssystem (20) zur Durchführung des Verfahrens nach einem der Ansprüche 1-12 ausgestaltet ist.

## Claims

1. A method for automatically monitoring a transformer device, comprising:
- detecting (101) transformer measurement value information indicating an electrical characteristic of the transformer device (10) to be monitored with a measurement device (21),
- detecting (102) humidity measurement value information with a humidity sensor (26, 27, 28), the humidity measurement value information indicating a humidity at the location of the transformer device (10), and
- generating (106), with an evaluation circuit (22), a monitoring result for the transformer device (10) depending on the transformer measurement value information and the humidity measurement value information,
**characterized in**
**that** depending on the humidity measurement value information at least a part of the transformer measurement value information is not considered in generating (106) the monitoring result.

2. The method of claim 1, wherein the transformer measurement value information comprises a plurality of transformer measurement values detected consecutively in time, the method comprising:
- evaluating a transformer measurement value of the plurality of transformer measurement values as plausible or non-plausible depending on the humidity measurement value information, and
- generating (106) the monitoring result independently of the transformer measurement value when the transformer measurement value is evaluated as non-plausible.

3. The method of claim 2, wherein the humidity measurement value information comprises a plurality of humidity measurement values detected consecutively in time, the method comprising:
assigning at least one temporally correlated moisture measurement value of the plurality of moisture measurement values to a transformer measurement value of the plurality of transformer measurement values, and
evaluating the transformer measurement value as plausible or non-plausible depending on the assigned at least one moisture measurement value.

4. The method of claim 3, wherein assigning at least one temporally correlated moisture measurement value comprises:
assigning at least one moisture measurement value of the plurality of moisture measurement values detected in a predetermined time range with respect to a detection time of a transformer measurement value to the transformer measurement value,
wherein preferably the predetermined time range is from a first time point before the detection time point of the transformer measurement value to a second time point after the detection time point of the transformer measurement value.

5. The method of any one of the preceding claims,
wherein the humidity sensor (26, 28, 29) comprises a rain sensor, wherein the humidity measurement value information indicates whether precipitation is present at the location of the humidity sensor (26, 28, 29) at a measurement time,
wherein preferably at least a part of the transformer measurement value information is not considered in generating the monitoring result when the humidity measurement value information indicates that precipitation is present at the location of the humidity sensor (26, 28, 29) at the measurement time.

6. The method of any one of the preceding claims,
wherein the humidity sensor (26, 28, 29) comprises an air humidity sensor, wherein the humidity measurement value information indicates at a measurement time the air humidity at the location of the humidity sensor (26, 28, 29),
wherein preferably at least a part of the transformer measurement value information is not considered in generating the monitoring result when the humidity measurement value information indicates that at the measurement time the humidity is above a predetermined humidity threshold value.

7. The method of claim 6,
wherein the humidity measurement value information indicates the air humidity at the location of the humidity sensor (26, 28, 29) at a plurality of consecutive measurement times,
wherein at least a portion of the transformer measurement value information is not considered in generating the monitoring result when a gradient of the air humidity over time is above a predetermined air humidity change threshold.

8. The method of any one of the preceding claims, wherein the transformer device (10) is arranged outdoors on a land area.

9. The method of any one of the preceding claims, wherein the transformer device (10) comprises a high voltage transformer (13).

10. The method of any one of the preceding claims, wherein the transformer device (10) comprises a transformer (13) and cable bushings (12) for cables (30) to the transformer (13).

11. The method of any one of the preceding claims, wherein the transformer measurement value information comprises a loss factor of the transformer device (10).

12. The method of any one of the preceding claims, wherein the humidity sensor (26, 28, 29) is arranged outdoors in an environment of the transformer device (10).

13. A monitoring system for a transformer device, comprising:
- a measurement device (21) configured to provide transformer measurement value information indicative of an electrical characteristic of the transformer device (10) to be monitored,
- a humidity sensor (26, 28, 29) configured to provide humidity measurement value information, the humidity measurement value information indicating humidity at the location of the transformer device (10), and
- an evaluation circuit (22) coupled to the measurement device (21) and the humidity sensor (26, 28, 29) and configured to generate a monitoring result for the transformer device (10) depending on the transformer measurement value information and the humidity measurement value information,
**characterized in**
**that** the evaluation circuit (22) is configured in such that, depending on the humidity measurement value information, it does not consider at least a part of the transformer measurement value information in generating (106) the monitoring result.

14. The monitoring system of claim 13, wherein the monitoring system (20) is configured to perform the method of any one of claims 1-12.

## Revendications

1. Procédé de surveillance automatique d'un appareil à transformateur, comprenant :
- la détection (101) d'une information de valeur de mesure de transformateur, laquelle indique une propriété électrique à surveiller de l'appareil à transformateur (10), à l'aide d'un dispositif de mesure (21),
- la détection (102) d'une information de valeur de mesure d'humidité à l'aide d'un capteur d'humidité (26, 27, 28), l'information de valeur de mesure d'humidité indiquant une humidité sur le site de l'appareil à transformateur (10), et
- la génération (106), à l'aide d'un circuit d'évaluation (22), d'un résultat de surveillance pour l'appareil à transformateur (10) en fonction de l'information de valeur de mesure de transformateur et de l'information de valeur de mesure d'humidité,
**caractérisé en ce**
**que**, en fonction de l'information de valeur de mesure d'humidité, au moins une partie de l'information de valeur de mesure de transformateur n'est pas prise en compte lors de la génération (106) du résultat de surveillance.

2. Procédé selon la revendication 1, dans lequel l'information de valeur de mesure de transformateur comprend de nombreuses valeurs de mesure de transformateur détectées successivement dans le temps, le procédé comprenant :
- l'évaluation d'une valeur de mesure de transformateur des nombreuses valeurs de mesure de transformateur, en fonction de l'information de valeur de mesure d'humidité, comme plausible ou non plausible, et
- la génération (106) du résultat de surveillance indépendamment de la valeur de mesure de transformateur lorsque la valeur de mesure de transformateur est évaluée comme non plausible.

3. Procédé selon la revendication 2, dans lequel l'information de valeur de mesure d'humidité comprend de nombreuses valeurs de mesure d'humidité détectées successivement dans le temps, le procédé comprenant :
l'attribution d'au moins une valeur de mesure d'humidité, corrélée dans le temps, des nombreuses valeurs de mesure d'humidité à une valeur de mesure de transformateur des nombreuses valeurs de mesure de transformateur, et
l'évaluation de la valeur de mesure de transformateur comme plausible ou non plausible en fonction de l'au moins une valeur de mesure d'humidité attribuée.

4. Procédé selon la revendication 3, dans lequel l'attribution de l'au moins une valeur de mesure d'humidité corrélée dans le temps comprend :
l'attribution d'au moins une valeur de mesure d'humidité des nombreuses valeurs de mesure d'humidité, laquelle a été détectée dans une plage de temps prédéterminée par rapport à un moment de détection d'une valeur de mesure de transformateur, à la valeur de mesure de transformateur,
la plage de temps prédéterminée variant de préférence d'un premier moment avant le moment de détection de la valeur de mesure de transformateur à un second moment après le moment de détection de la valeur de mesure de transformateur.

5. Procédé selon l'une des revendications précédentes,
dans lequel le capteur d'humidité (26, 28, 29) comprend un capteur de pluie, l'information de valeur de mesure d'humidité indiquant la présence d'une précipitation sur le site du capteur d'humidité (26, 28, 29) à un moment de mesure,
au moins une partie de l'information de valeur de mesure de transformateur n'étant de préférence pas prise en compte lors de la génération du résultat de surveillance lorsque l'information de valeur de mesure d'humidité indique la présence d'une précipitation sur le site du capteur d'humidité (26, 28, 29) au moment de mesure.

6. Procédé selon l'une des revendications précédentes,
dans lequel le capteur d'humidité (26, 28, 29) comprend un capteur d'humidité de l'air, l'information de valeur de mesure d'humidité indiquant l'humidité de l'air sur le site du capteur d'humidité (26, 28, 29) à un moment de mesure,
au moins une partie de l'information de valeur de mesure de transformateur n'étant de préférence pas prise en compte lors de la génération du résultat de surveillance lorsque l'information de valeur de mesure d'humidité indique que l'humidité de l'air se situe au-dessus d'une valeur seuil prédéterminée d'humidité de l'air au moment de mesure.

7. Procédé selon la revendication 6,
dans lequel l'information de valeur de mesure d'humidité indique l'humidité de l'air sur le site du capteur d'humidité (26, 28, 29) à plusieurs moments de mesure successifs dans le temps,
au moins une partie de l'information de valeur de mesure de transformateur n'étant pas prise en compte lors de la génération du résultat de surveillance lorsqu'un gradient de l'humidité de l'air se situe, au cours du temps, au-dessus d'une valeur seuil prédéterminée de variation d'humidité de l'air.

8. Procédé selon l'une des revendications précédentes, dans lequel l'appareil à transformateur (10) est disposé en plein air sur une surface terrestre.

9. Procédé selon l'une des revendications précédentes, dans lequel l'appareil à transformateur (10) comprend un transformateur haute tension (13).

10. Procédé selon l'une des revendications précédentes, dans lequel l'appareil à transformateur (10) comprend un transformateur (13) et des passages de câble (12) pour des câbles (30) jusqu'au transformateur (13).

11. Procédé selon l'une des revendications précédentes, dans lequel l'information de valeur de mesure de transformateur comprend un facteur de perte de l'appareil à transformateur (10).

12. Procédé selon l'une des revendications précédentes, dans lequel le capteur d'humidité (26, 28, 29) est disposé en plein air à proximité de l'appareil à transformateur (10).

13. Système de surveillance d'un appareil à transformateur, comprenant :
- un dispositif de mesure (21) conçu pour fournir une information de valeur de mesure de transformateur, laquelle indique une propriété électrique à surveiller de l'appareil à transformateur (10),
- un capteur d'humidité (26, 28, 29) conçu pour fournir une information de valeur de mesure d'humidité, laquelle information de valeur de mesure d'humidité indique une humidité sur le site de l'appareil à transformateur (10), et
- un circuit d'évaluation (22) couplé au dispositif de mesure (21) et au capteur d'humidité (26, 28, 29) et conçu pour générer un résultat de surveillance pour l'appareil à transformateur (10) en fonction de l'information de valeur de mesure de transformateur et de l'information de valeur de mesure d'humidité,
**caractérisé en ce**
**que** le circuit d'évaluation (22) est conçu de façon à ne pas prendre en compte lors de la génération (106) du résultat de surveillance, en fonction de l'information de valeur de mesure d'humidité, au moins une partie de l'information de valeur de mesure de transformateur.

14. Système de surveillance selon la revendication 13, le système de surveillance (20) étant conçu pour la mise en oeuvre du procédé selon l'une des revendications 1 à 12.
